# EUROPÄISCHE PATENTSCHRIFT

(11) **EP 3 430 652 B1**
(45) Veröffentlichungstag und Bekanntmachung des Hinweises auf die Patenterteilung: **26.08.2020**
(21) Anmeldenummer: 17711143.2
(22) Anmeldetag: 15.03.2017
(51) Int. Cl.: H01L 41/08, H02N 2/00, H02N 2/02, H02N 2/04, H02N 2/06

(54) **PIEZOELEKTRISCHER ANTRIEB**
PIEZOELECTRIC DRIVE
L'ENTRAÎNEMENT PIÉZOÉLECTRIQUE

(30) Priorität: 15.03.2016 DE 102016104803
(43) Veröffentlichungstag der Anmeldung: 23.01.2019
(73) Patentinhaber: Physik Instrumente (PI) GmbH & Co. KG, 76228 Karlsruhe (DE)
(72) Erfinder: MARTH, Harry, 76337 Waldbronn (DE); BOCSKAI, Dominik, 76473 Iffezheim (DE)
(74) Vertreter: Grünecker Patent- und Rechtsanwälte PartG mbB
(86) Internationale Anmeldenummer: PCT/EP2017/056114
(87) Internationale Veröffentlichungsnummer: WO 2017/158017

(56) Entgegenhaltungen:
- JP-A- S6 258 883
- US-A- 4 613 782
- US-A- 5 563 465

## Beschreibung

Die vorliegende Erfindung betrifft einen piezoelektrischen Schreitantrieb nach dem Oberbegriff des Anspruchs 1, umfassend wenigstens eine piezoelektrische Antriebsvorrichtung mit wenigstens zwei unabhängig voneinander antreibbaren Antriebsabschnitten, auf die jeweils wenigstens zwei piezoelektrische Aktuatoren wirken, und einen Läufer, der bei Beaufschlagung der Aktuatoren mit Steuerspannungen einen Vorschub durch wenigstens einen der Antriebsabschnitte erfährt.

Ein piezoelektrischer Schreitantrieb nach dem Oberbegriff des Anspruchs 1 ist aus der JP H02-146971 A bekannt.

Aus der US 4,613,782 ist ein Piezoelektrischer Schreitantrieb bekannt, wobei piezoelektrischen Antriebsvorrichtungen jeweils einen Antriebsabschnitt aufweisen, auf den zwei piezoelektrische Aktuatoren wirken, und der durch eine Feder vorgespannt ist. Die Antriebsabschnitte sind entlang der Vorschubrichtung des Läufers verteilt.

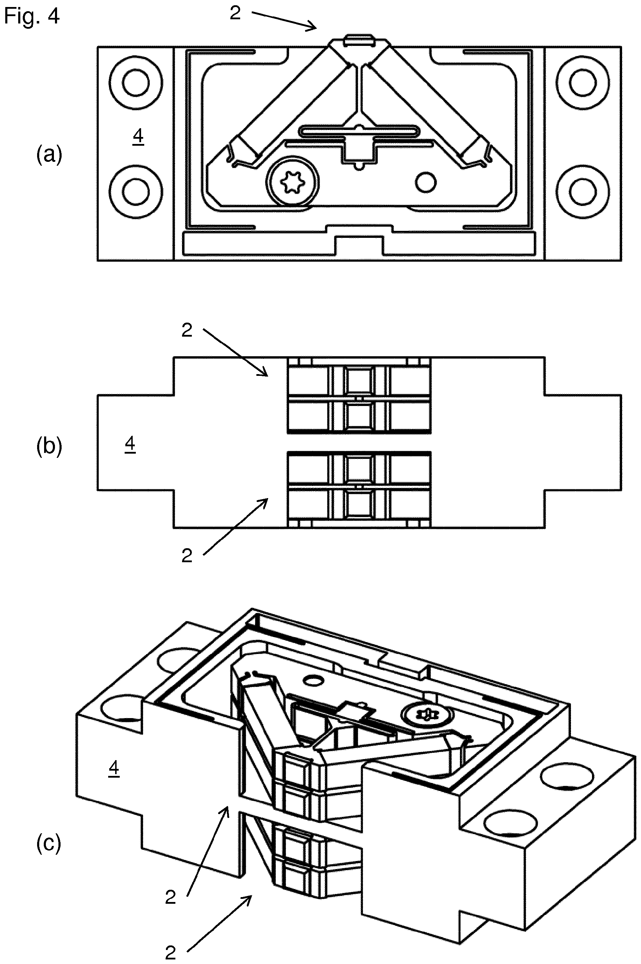

Aus der US 5,563,465 ist ein Piezoelektrischer Schreitantrieb, umfassend wenigstens eine piezoelektrische Antriebsvorrichtung mit wenigstens zwei unabhängig voneinander antreibbaren Antriebsabschnitten, auf die jeweils wenigstens zwei piezoelektrische Aktuatoren wirken, und einen Läufer, der bei Beaufschlagung der Aktuatoren mit Steuerspannungen einen Vorschub durch wenigstens einen der Antriebsabschnitte erfährt, bekannt. Das Dokument JPS6258883 offenbart in der Abb. 4 einen einzigen Antriebskopf 8 verbunden mit zwei gewinkelten piezoelektrische Aktuatoren (1, 2) und zwei Federn (3,4), der einen Antriebskörper (9) fortbewegt.

Bei diesem piezoelektrischen Schreitantrieb hat sich als nachteilig herausgestellt, dass eine präzise Steuerung des Vorschubs des Läufers aufgrund dessen Trägheit erschwert wird.

Der vorliegenden Erfindung liegt die Aufgabe zu Grunde, einen piezoelektrischen Schreitantrieb nach dem Oberbegriff des Anspruchs 1 dahingehend zu verbessern, um eine präzisere Steuerung des Vorschubs des Läufers zu ermöglichen.

Die Aufgabe der Erfindung wird durch den Gegenstand des Anspruchs 1 gelöst. Vorteilhafte Weiterentwicklungen der Erfindung werden in den Unteransprüchen beansprucht.

Der erfindungsgemäße, piezoelektrische Schreitantrieb umfasst wenigstens eine piezoelektrische Antriebsvorrichtung mit wenigstens zwei unabhängig voneinander antreibbaren Antriebsabschnitten, auf die jeweils wenigstens zwei piezoelektrische Aktuatoren wirken, und einen Läufer, der bei Beaufschlagung der Aktuatoren mit Steuerspannungen einen Vorschub durch wenigstens einen der Antriebsabschnitte erfährt, wobei wenigstens einer der Antriebsabschnitte in Abwesenheit von an den Aktuatoren anliegenden Steuerspannungen derart gegen den Läufer vorgespannt ist, dass dieser den Vorschub des Läufers blockiert. Die Vorspannkräfte beider Antriebsabschnitte wirken vorzugsweise im Wesentlichen senkrecht oder exakt senkrecht zur Vorschubrichtung (auch: Antriebsrichtung) des Läufers. Die Antriebsabschnitte sind durch Beaufschlagung der piezoelektrischen Aktuatoren mit Steuerspannungen unabhängig voneinander auslenkbar, um die auf den Läufer ausgeübten Vorspannkräfte zu verringern oder vollständig aufzuheben und um Antriebskräfte auf den Läufer zur Erzielung eines Vorschubs bzw. einer Vorschubbewegung zu übertragen. Vorzugsweise sind die Antriebsabschnitte jeder Antriebsvorrichtung quer oder senkrecht zur Vorschubrichtung des Läufers benachbart angeordnet.

Wesentliche Bestandteile des erfindungsgemäßen Piezoschreitantriebs sind demnach mehrere piezokeramische Aktoren (auch: Aktuatoren), die auf die jeweils zugeordneten Antriebsabschnitte wirken, welche gegen den beweglich geführten Läufer vorgespannt sind. Durch aufeinander abgestimmte Steuerspannungen, mit denen die beiden einem Antriebsabschnitt zugeordneten Aktuatoren beaufschlagt werden, gelingt eine Art Schreitbewegung der Antriebsabschnitte, die zu einem Vorschub des Läufers führt. Die Verwendung von piezoelektrischen Aktoren ermöglicht hierbei kleinste Schritt- und Vorschubbewegungen, sodass eine hohe Bewegungsauflösung erreicht wird, wobei innerhalb eines Schreitbewegungsschrittes Auflösungen von weit unter einem Nanometer erzielt werden können. Ein variabler Stellweg kann durch eine variable Läuferlänge erzielt werden.

Die Vorspannung wenigstens eines der Antriebsabschnitte gegen den Läufer sorgt für die Selbsthemmung des Antriebs in Ruhe und im ausgeschalteten Zustand. Dadurch verbraucht er im ausgeschalteten Zustand keine Energie, er erwärmt sich hierbei nicht und hält die Position mechanisch stabil. Anwendungen mit geringer Einschaltdauer, die eine hohe zeitliche und Temperaturstabilität erfordern, profitieren von diesen Eigenschaften.

Die Bewegung bzw. Deformation der piezokeramischen Aktoren beruht auf kristallinen Effekten und ist keinem Verschleiß ausgesetzt. Die Ankopplung der Antriebsabschnitte an den Läufer ist bei einem Vorschub des Läufers, der alleine durch ein physikalisches Klemmen und Abheben der Antriebsabschnitte erzielt wird, nur sehr geringen Gleitreibungseffekten unterworfen. Dadurch kann eine sehr präzise Steuerung des Vorschubs des Läufers realisiert werden. Allerdings ist mit dem erfindungsgemäßen Schreitantrieb auch eine Vorschubbewegung des Läufers möglich, bei welchem die Antriebsabschnitte nicht von dem Läufer abheben.

Es kann sich als sinnvoll erweisen, wenn die Antriebsvorrichtung einen formveränderlichen Rahmen aufweist, in welchen die Aktuatoren derart eingesetzt sind, dass jeweils die beiden auf einen Antriebsabschnitt wirkenden Aktuatoren mit einem ihrer jeweiligen Enden an dem ihnen gemeinsamen Antriebsabschnitt des Rahmens anliegen und sich mit ihrem anderen Ende an einem Abstützabschnitt des Rahmens abstützen. Die über den Rahmen integrierte Antriebsvorrichtung bildet eine kompakte Baugruppe, die flexibel einsetzbar und vielseitig verwendbar ist.

Hierbei kann es von Vorteil sein, wenn der Rahmen elastisch verformbare Abschnitte aufweist. Durch den Einsatz elastisch verformbarer Abschnitte lassen sich gezielt örtlich benötigte Flexibilitäten bzw. Elastizitäten des Rahmens erreichen.

Es kann hilfreich sein, wenn wenigstens einer der elastisch verformbaren Abschnitte als Federabschnitt oder als Festkörpergelenk ausgebildet ist, wobei vorzugsweise wenigstens einer der elastisch verformbaren Abschnitte zwischen wenigstens einem der Abstützabschnitte und einer Basis (Lagerstelle) des Rahmens und/oder zwischen wenigstens einem der Antriebsabschnitte und einer Basis (Lagerstelle) des Rahmens angeordnet ist. In diesen Bereichen des Rahmens werden insbesondere erhöhte Flexibilitäten bzw. Elastizitäten benötigt, damit zum Einen die Antriebsabschnitte eine (Schreit-)Bewegung aufgrund der entsprechenden Krafteinwirkung durch die ihnen zugeordneten Aktuatoren vollführen können, und zum Anderen die Aktuatoren derart in den Rahmen eingesetzt werden können, dass keine hohen inneren Spannungen, insbesondere Scherspannungen, resultieren bzw. dass eine einfache Ausrichtung bzw. Montage der Aktuatoren in dem Rahmen möglich ist.

Die Antriebsvorrichtung ist näherungsweise in Form eines Dreiecks ausgebildet, an dessen Spitze die Antriebsabschnitte angeordnet sind. Vorzugsweise bilden die Aktuatoren wenigstens abschnittsweise die Schenkel des Dreiecks und sind gelenkig an einer Basis des Dreiecks festgelegt. Jeder der Antriebsabschnitte ist einzeln federnd bzw. elastisch gegenüber der Basis des Dreiecks gelagert ist. Vorzugsweise bildet der Rahmen ein gleichschenkliges Dreieck, an dessen Spitze sich die Antriebsabschnitte befinden, wobei die Aktuatoren die Schenkel des Dreiecks bilden. Die Abstützabschnitte sind beispielsweise gelenkig an einer Basis des Dreiecks festgelegt und jeder der Antriebsabschnitte kann über elastische Federabschnitte einzeln mit der Basis des Dreiecks verbunden sein. Die auf denselben Antriebsabschnitt wirkenden Aktuatoren wirken vorzugsweise in Arbeitsrichtungen, die zumindest abschnittsweise senkrecht und/oder parallel zu einer die Vorschubrichtung des Läufers einschließenden Ebene verlaufen. Es ist wünschenswert, dass die Arbeitsrichtungen der an demselben Antriebsabschnitt anliegenden Aktuatoren im Winkel von 45° bis 135°, idealerweise 90°, zueinander stehen.

Die Antriebsvorrichtung ist spiegelsymmetrisch aufgebaut. Diese Variante begünstigt die gleichmäßige Aufbringung der Antriebskräfte über die Antriebsabschnitte auf den Läufer unter Minimierung von Unregelmäßigkeiten in der Vorschubbewegung. Dabei ist die Antriebsvorrichtung in Bezug auf eine erste Symmetrieebene, die die Vorschubrichtung des Läufers einschließt und zwischen den Antriebsabschnitten derselben Antriebsvorrichtung verläuft, spiegelsymmetrisch aufgebaut.

Dabei kann es sinnvoll sein, wenn die Antriebsvorrichtung in Bezug auf eine zweite Symmetrieebene, die senkrecht zur Vorschubrichtung des Läufers ausgerichtet ist und beide Antriebsabschnitte derselben Antriebsvorrichtung schneidet, spiegelsymmetrisch aufgebaut ist.

Es mag überdies von Nutzen sein, wenn der Schreitantrieb wenigstens zwei Antriebsvorrichtungen aufweist, die auf derselben Seite oder auf unterschiedlichen Seiten des Läufers angeordnet sind, wobei die Antriebsvorrichtungen vorzugsweise spiegelsymmetrisch angeordnet sind und/oder die Antriebsabschnitte spiegelsymmetrisch auslenkbar sind und/oder die den die Antriebsabschnitten zugeordneten Aktuatoren spiegelsymmetrisch verschaltet sind. Dabei kann es hilfreich sein, wenn die zugeordneten Aktuatoren von jeweils zwei Antriebsabschnitten unterschiedlicher Antriebsvorrichtungen paarweise verschaltet sind und bei Beaufschlagung der zugeordneten Aktuatoren mit Steuerspannungen gleichzeitig auslenkbar sind, um gleichgerichtete Antriebskräfte zur Bewerkstelligung des Vorschubs auf den Läufer zu übertragen. Symmetrien im Hinblick auf die Anordnung, Ansteuerung oder Verschaltung der beiden Antriebsvorrichtungen sind möglicherweise in folgenden Symmetrieebenen gegeben:
- Eine erste Symmetrieebene, die die Vorschubrichtung des Läufers einschließt und in der Ebene des Läufers zwischen Antriebsabschnitten unterschiedlicher Antriebsvorrichtungen verläuft.
- Eine zweite Symmetrieebene, die die Vorschubrichtung des Läufers einschließt und die beiden Antriebsvorrichtungen senkrecht zur Ebene des Läufers zwischen den Antriebsabschnitten jeweils derselben Antriebsvorrichtung schneidet.
- Eine dritte Symmetrieebene, die senkrecht zur Vorschubrichtung und senkrecht zur Ebene des Läufers verläuft und die Antriebsabschnitte beider Antriebsvorrichtungen schneidet.

Es kann sich als vorteilhaft erweisen, wenn der Läufer elastisch verformbar ausgebildet und/oder gelagert ist und in Abwesenheit der Steuerspannungen an den Aktuatoren durch Rückstellkräfte aufgrund elastischer Verformung gegenüber der Antriebsvorrichtung vorgespannt ist. Diese Variante ist vorteilhaft, wenn die Antriebsvorrichtung lediglich einseitig auf den Läufer einwirkt.

Ferner kann es sich als vorteilhaft erweisen, wenn wenigstens eine Antriebsvorrichtung an einem Grundrahmen angeordnet ist, wobei der Grundrahmen elastisch verformbare Abschnitte, bevorzugt in Form von Festkörpergelenken, aufweist, so dass die Antriebsvorrichtung an dem Grundrahmen derart elastisch lagerbar ist, dass wenigstens einer ihrer Antriebsabschnitte in Abwesenheit der Steuerspannungen an den Aktuatoren durch Rückstellkräfte aufgrund elastischer Verformung gegenüber dem Läufer vorgespannt ist. Hierbei kann insbesondere durch den Einsatz von Stellschrauben auf einfache Weise eine definierte Vorspannung der Antriebsabschnitte gegen den Läufer realisiert werden.

Es kann auch sinnvoll sein, wenn die wenigstens eine Antriebsvorrichtung und der Läufer auf demselben Grundrahmen angeordnet sind, wobei die wenigstens eine Antriebsvorrichtung und der Läufer relativ federnd zueinander an dem Grundrahmen gelagert sind. Beispielsweise sind die wenigstens eine Antriebsvorrichtung und der Läufer auf verschiedenen Abschnitten des Grundrahmens angeordnet, die zueinander beweglich und federnd verbunden sind, wobei die verschiedenen Abschnitte des Grundrahmens beispielsweise über ein oder mehrere Festkörpergelenke verbunden sind.

Darüber hinaus kann es sich als vorteilhaft erweisen, wenn der Läufer derart gelagert und/oder ausgebildet ist und/oder die Antriebsvorrichtung derart gelagert ist und/oder der Grundrahmen derart konfiguriert ist, dass eine Zunahme der Vorspannkraft zwischen einem der Antriebsabschnitte der Antriebsvorrichtung und dem Läufer zu einer Abnahme der Vorspannkraft zwischen einem anderen Antriebsabschnitt dieser Antriebsvorrichtung und dem Läufer führt. Hierdurch wird auf rein mechanische Weise eine Verringerung der Vorspannkraft bis hin zum völligen Abheben des entsprechenden Antriebsabschnitts vom Läufer erzielt, was die Ansteuerung des Schreitantriebs deutlich vereinfacht.

Ein weiterer Aspekt der vorliegenden Erfindung betrifft ein Verfahren zur Ansteuerung eines piezoelektrischen Schreitantriebs nach einer der vorangehenden Ausführungen, umfassend die Schritte:
- Schritt A: Ansteuern der wenigstens einem zweiten Antriebsabschnitt zugeordneten, zweiten Aktuatoren und gegebenenfalls Ansteuern der wenigstens einem ersten Antriebsabschnitt zugeordneten, ersten Aktuatoren, so dass die von dem ersten Antriebsabschnitt auf den Läufer aufgebrachte die Vorspannkraft verringert oder aufgehoben wird;
- Schritt B: Ansteuern der zweiten Aktuatoren, so dass der zweite Antriebsabschnitt Antriebskräfte auf den Läufer überträgt und der Läufer einen Vorschub in Antriebsrichtung erfährt;
- Schritt C: Ändern der an den zweiten Aktuatoren angelegten Steuerspannungen und gegebenenfalls Ändern der an den ersten Aktuatoren angelegten Steuerspannungen, um den Kontakt zwischen dem ersten Antriebsabschnitt und dem Läufer wiederherzustellen, wobei die ersten und zweiten Antriebsabschnitte in Antriebsrichtung des Läufers gegeneinander versetzt sind;
- Schritt D: Ansteuern der ersten Aktuatoren und gegebenenfalls Ansteuern der zweiten Aktuatoren, so dass die von dem zweiten Antriebsabschnitt auf den Läufer aufgebrachte Vorspannkraft verringert oder aufgehoben wird;
- Schritt E: Ansteuern der ersten Aktuatoren, so dass der erste Antriebsabschnitt Antriebskräfte auf den Läufer überträgt und der Läufer einen Vorschub in Antriebsrichtung erfährt;
- Schritt F: Ändern der an den ersten Aktuatoren angelegten Steuerspannungen und gegebenenfalls Ändern der an den zweiten Aktuatoren angelegten Steuerspannungen, um den Kontakt zwischen dem zweiten Antriebsabschnitt und dem Läufer wiederherzustellen; und gegebenenfalls
- Wiederholen der Schritte A bis F, wobei Schritt B bei jeder Wiederholung derart abgewandelt ist, dass ein Ansteuern der zweiten Aktuatoren und der ersten Aktuatoren erfolgt, so dass der zweite Antriebsabschnitt einen Vorschub des Läufers in Antriebsrichtung bewirkt und der erste Antriebsabschnitt eine Bewegung im Wesentlichen entgegengesetzt zu der Antriebsrichtung ausführt.

Die Formulierung "gegebenenfalls" zeigt an, dass die zusätzliche Ansteuerung der ersten bzw. zweiten Aktuatoren in den Schritten A und D optional erfolgt, vorzugsweise mit einer phasenversetzten oder gegenphasigen Steuerspannung im Vergleich zu der an den jeweils anderen Aktuatoren angelegten Steuerspannung.

Das zuvor beschriebene Verfahren gewährleistet, dass sich während des gesamten Vorschubs des Läufers jeweils wenigstens ein Antriebsabschnitt mit dem Läufer in Kontakt befindet. Dieser Vorschub ist analog zu einer menschlichen Gehbewegung fließend, wo sich jeweils ein Fuß in Kontakt mit dem Boden befindet. Die Vorschubbewegung des Läufers kann somit optimal kontrolliert werden und ein unbeabsichtigter Vorschub aufgrund einer Trägheit des Läufers wird eliminiert. Gleichzeitig wird eine unbeabsichtigte Bewegung des Läufers aufgrund seiner Gewichtskraft reduziert bzw. eliminiert. Die Ansteuerung der Aktuatoren erfolgt hierbei mit einer Frequenz, die außerhalb und insbesondere unterhalb, bevorzugt deutlich unterhalb der Resonanzfrequenz der Aktuatoren liegt. Diese Frequenz liegt zudem unterhalb von 20 kHz.

Es kann sich als vorteilhaft erweisen, wenn beim zuvor beschriebenen Verfahren bei Schritt B zusätzlich ein Ansteuern der ersten Aktuatoren erfolgt, so dass der erste Antriebsabschnitt eine Bewegung im Wesentlichen entgegengesetzt zu der Antriebsrichtung ausführt und/oder bei Schritt E zusätzlich ein Ansteuern der zweiten Aktuatoren erfolgt, so dass der zweite Antriebsabschnitt eine Bewegung im Wesentlichen entgegengesetzt zu der Antriebsrichtung ausführt. Durch die hierbei erzielte Rückstellbewegung der Antriebsabschnitte gelingt eine noch effektivere und insbesondere dynamischere Antriebsvorrichtung.

### Kurze Beschreibung der Figuren

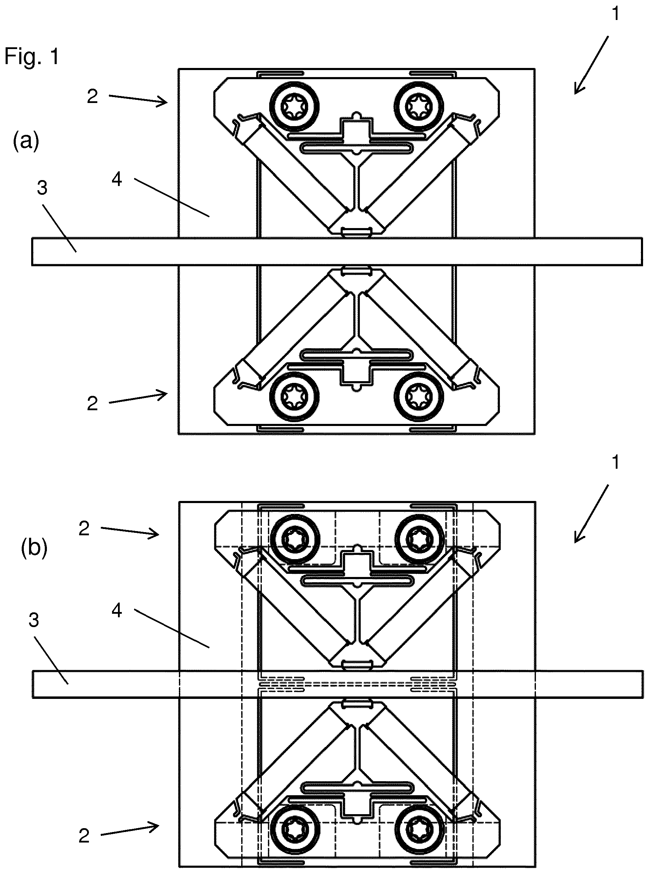

- Figur 1: zeigt eine Seitenansicht eines piezoelektrischen Schreitantriebs nach einem ersten Ausführungsbeispiel der Erfindung, bei welchem zwei identische Antriebsvorrichtungen spiegelsymmetrisch gegenüberliegend auf unterschiedlichen Seiten des Läufers angeordnet sind, wobei in Ansicht (a) verdeckte Konturen unsichtbar sind und in Ansicht (b) verdeckte Konturen sichtbar dargestellt sind.

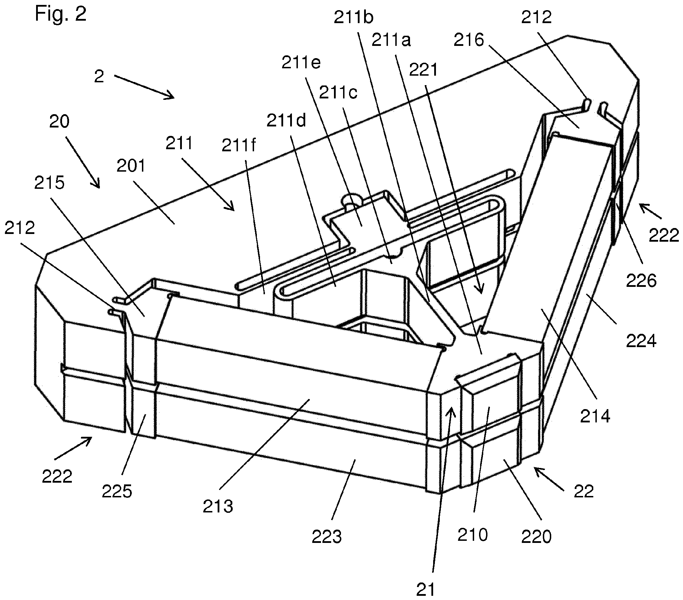

- Figur 2: zeigt eine perspektivische Ansicht einer Antriebsvorrichtung eines erfindungsgemäßen piezoelektrischen Schreitantriebs.

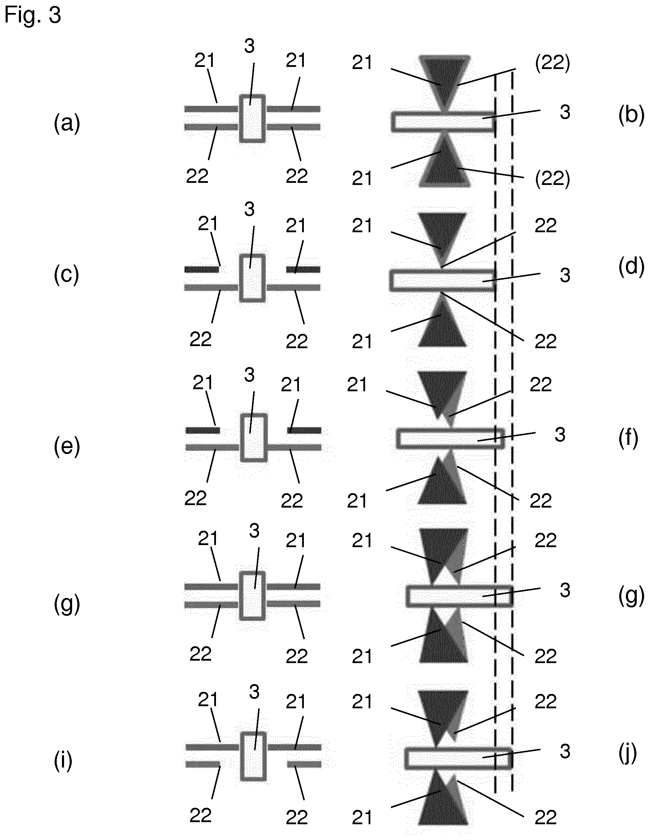

- Figur 3: zeigt schematische Ansichten (a bis j) der Bewegungsabläufe des Läufers und der Antriebsabschnitte beim Vorschub des Läufers ausgehend von einem spannungslosen Zustand in unterschiedlichen Ansichten.
- Figur 4: zeigt verschiedene Ansichten (a bis c) einer Anordnung von Antriebsvorrichtungen für einen piezoelektrischen Schreitantrieb nach einem zweiten Ausführungsbeispiel der Erfindung, wobei zwei identische Antriebsvorrichtungen parallel versetzt und benachbart zueinander in sich überdeckender Weise angeordnet sind und dafür ausgelegt sind, von derselben Seite eines Läufers auf diesen einzuwirken.

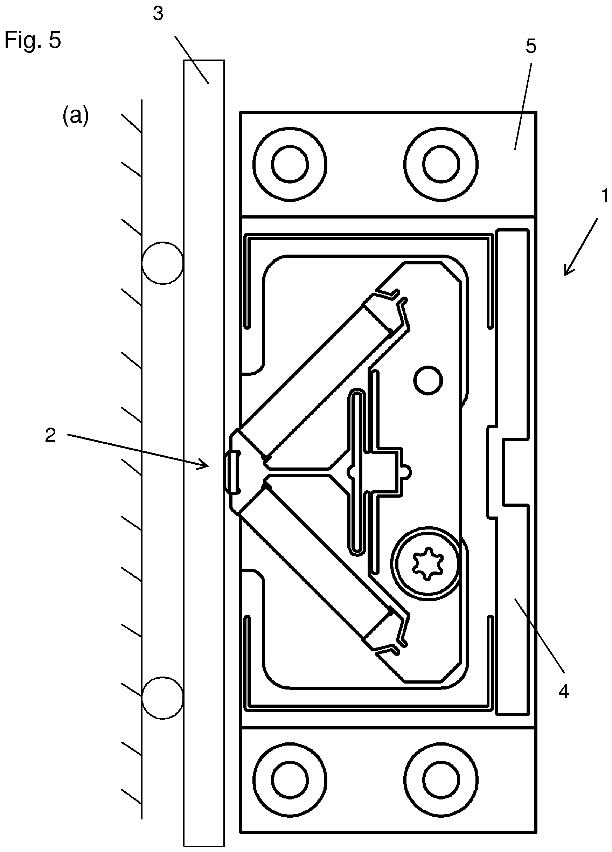

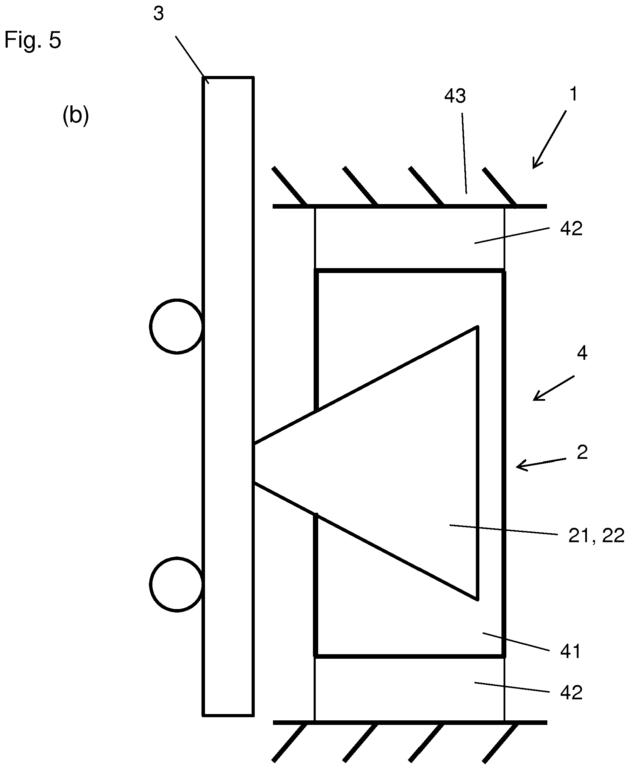

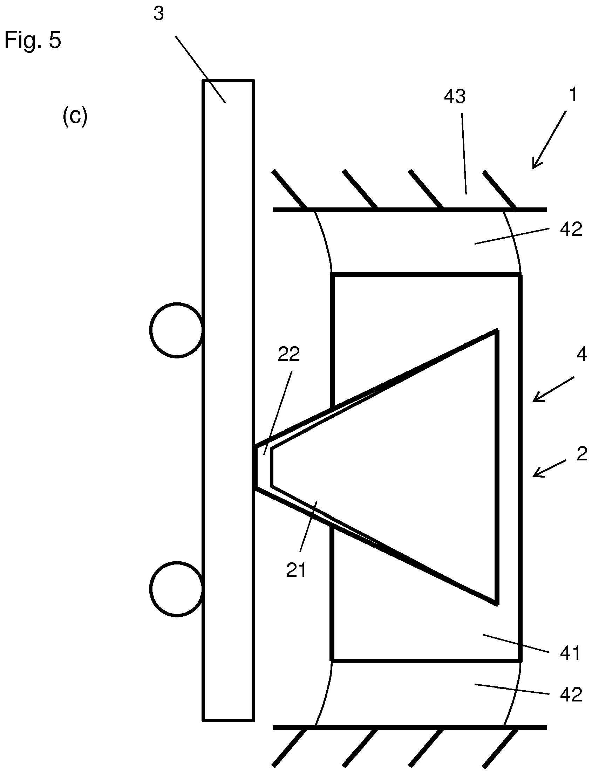

- Figur 5: zeigt verschiedene Seitenansichten (a bis c) eines piezoelektrischen Schreitantriebs nach einem zweiten Ausführungsbeispiel der Erfindung, wobei der Läufer rollend gegenüber einem Festlager gelagert ist und die Antriebsvorrichtungen von derselben Seite auf den Läufer einwirken, wobei Ansicht (a) eine detaillierte Seitenansicht des erfindungsgemäßen Schreitantriebs nach dem zweiten Ausführungsbeispiel ist, wobei Ansicht (b) eine schematische Seitenansicht des Schreitantriebs aus Ansicht (a) in einem spannungslosen Zustand in Abwesenheit von an den Aktuatoren anliegenden Steuerspannungen zeigt und Ansicht (c) eine schematische Seitenansicht des Schreitantriebs aus Ansicht (b) in einem Zustand zeigt, in welchem die wenigstens einem der Antriebsabschnitte zugeordneten Aktuatoren mit Steuerspannungen beaufschlagt sind, sodass sich der jeweilige Antriebsabschnitt unter Erhöhung der Vorspannkraft zwischen diesem Antriebsabschnitt und dem Läufer sowie unter Verformung eines die Antriebsvorrichtung lagernden Grundrahmens von dem Läufer abdrückt und somit der andere Antriebsabschnitt von dem Läufer abhebt.

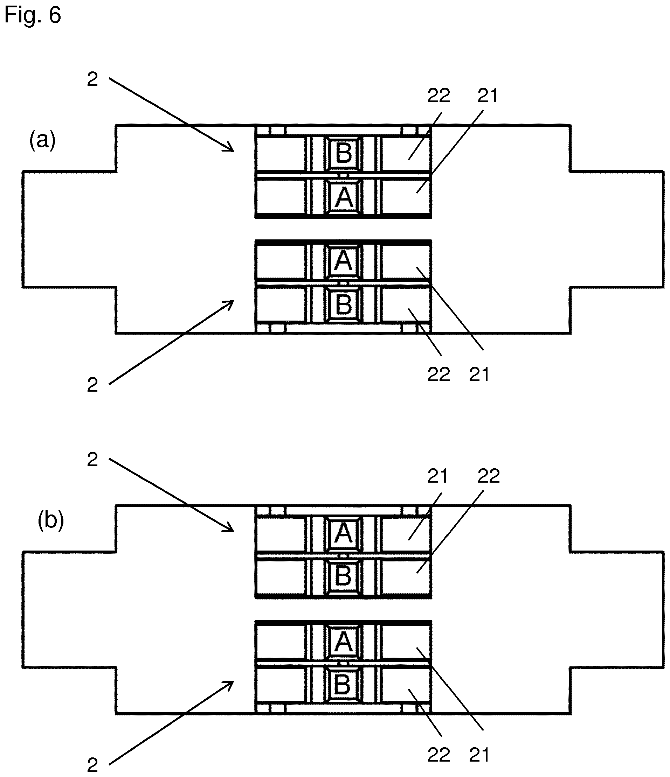

- Figur 6: zeigt Draufsichten unterschiedlicher Anordnungen von Antriebsvorrichtungen für einen piezoelektrischen Schreitantrieb nach dem zweiten Ausführungsbeispiel der Erfindung, wobei die beiden Antriebsvorrichtungen gemäß Ansicht (a) spiegelsymmetrisch benachbart zueinander angeordnet bzw. verschaltet sind und gemäß Ansicht (b) parallel versetzt zueinander angeordnet bzw. verschaltet sind.

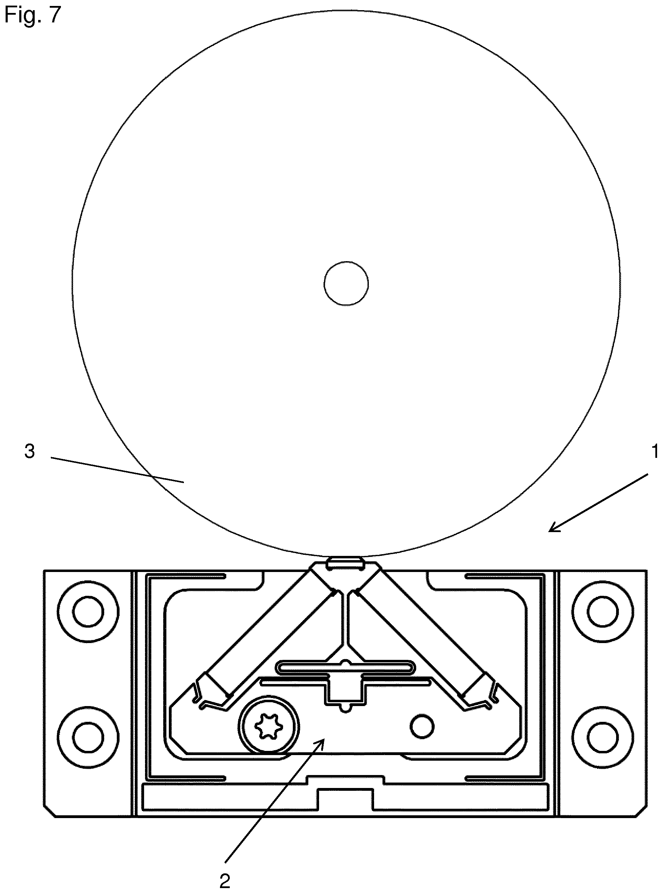

- Figur 7: zeigt eine Seitenansicht eines piezoelektrischen Schreitantriebs nach einem dritten Ausführungsbeispiel der Erfindung, wobei die Anordnung der Antriebsvorrichtung identisch zum zweiten Ausführungsbeispiel ausgebildet ist, aber der Läufer als Drehscheibe ausgebildet ist und die Antriebsvorrichtungen von derselben Seite im Wesentlichen radial auf den als Drehscheibe ausgebildeten Läufer einwirken.

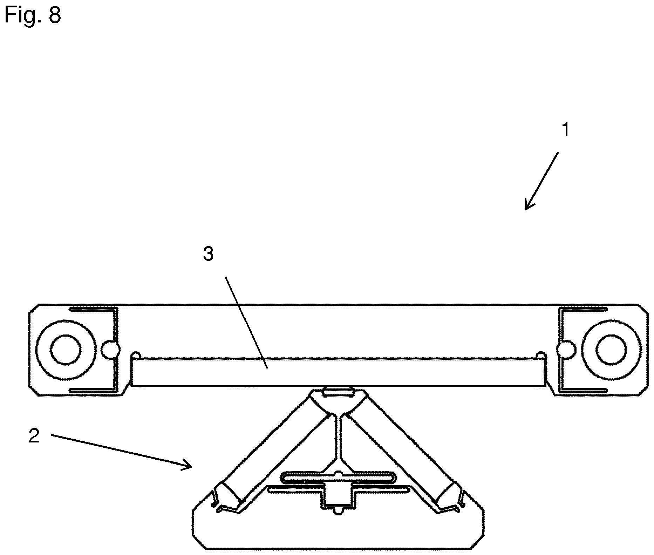

- Figur 8: zeigt eine Seitenansicht eines piezoelektrischen Schreitantriebs nach einem vierten Ausführungsbeispiel der Erfindung, wobei der Läufer elastisch verformbar gelagert ist und die Antriebsvorrichtungen von derselben Seite auf den Läufer einwirken.

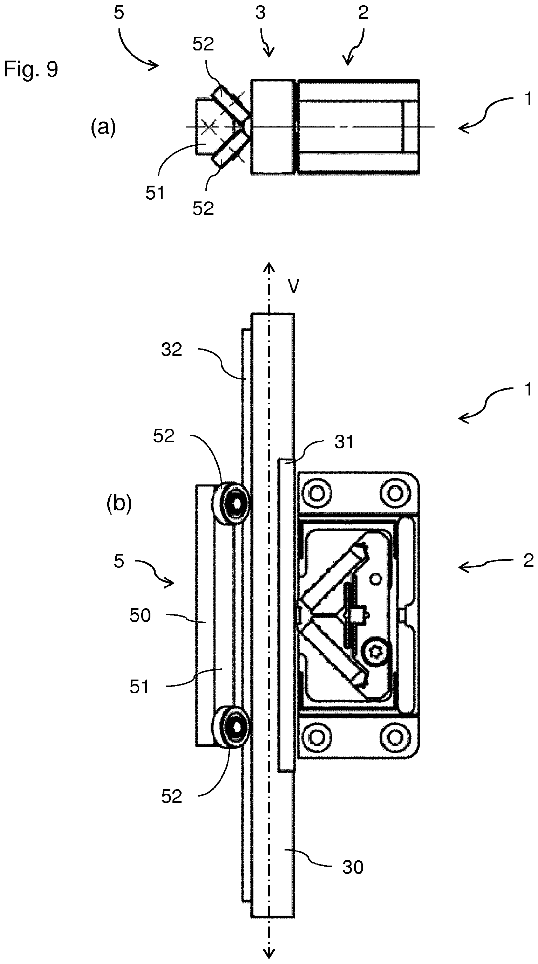

- Fig. 9: zeigt in Ansicht (a) eine Draufsicht und in Ansicht (b) eine Seitenansicht eines piezoelektrischen Schreitantriebs 1 nach einem fünften Ausführungsbeispiel der Erfindung, umfassend eine spezielle Führungseinrichtung für die Vorschubbewegung des Läufers, die eine selbständige Ausrichtung der Antriebsvorrichtung gegenüber dem Läufer ermöglicht.

### Detaillierte Beschreibung der bevorzugten Ausführungsbeispiele

Bevorzugte Ausführungsbeispiele der Erfindung werden nachstehend mit Bezug auf die beiliegenden Figuren beschrieben:

### Erstes Ausführungsbeispiel (Fig. 1 bis 3)

Der in Figur 1 (a) und (b) dargestellte, piezoelektrische Schreitantrieb 1 nach dem ersten Ausführungsbeispiel der Erfindung umfasst zwei baugleiche piezoelektrische Antriebsvorrichtungen 2, die gemäß der Darstellung in Fig. 2 jeweils zwei unabhängig voneinander antreibbare Antriebsabschnitte 21, 22 aufweisen, auf die jeweils zwei piezoelektrische Aktuatoren 213, 214, 223, 224 wirken. Es handelt sich z.B. um quaderförmige Aktuatoren 213, 214, 223, 224 mit Abmessungen von 3 × 3 × 13,5 mm. Die Antriebsvorrichtungen 2 stehen sich spiegelsymmetrisch angeordnet und verschaltet gegenüber, um zwischen sich einen Läufer 3 aufzunehmen, der bei Beaufschlagung der Aktuatoren 213, 214, 223, 224 mit entsprechenden Steuerspannungen einen Vorschub durch wenigstens einen der Antriebsabschnitte 21, 22 erfährt. Die Antriebsvorrichtungen 2 sind auf einem im Wesentlichen quadratischen Grundrahmen 4, der - wie insbesondere anhand Figur 1 (b) zu erkennen - elastisch verformbare Abschnitte in Form von Festkörpergelenken aufweist, montiert. In Figur 1, in nicht näher gezeigter Weise, sind die Antriebsvorrichtungen 2 mithilfe von Stellschrauben gegen den Läufer 3 vorgespannt, indem die über Festkörpergelenke miteinander verbundenen Teile des Grundrahmens 4 gegeneinander verspannt sind.

Der Läufer 3 ist im vorliegenden Fall ein lineares, nahezu quaderförmiges Element mit Längskanten, die sich parallel zu der Bewegungsrichtung bzw. Vorschubrichtung des Läufers 3 erstrecken. Erfindungsgemäß sind die Antriebsabschnitte 21, 22 in Abwesenheit von an den Aktuatoren 213, 214, 223, 224 anliegenden Steuerspannungen derart gegen den Läufer 3 vorgespannt, dass sie den Vorschub des Läufers 3 blockieren. Die Vorspannkräfte aller Antriebsabschnitte 21, 22 wirken dabei senkrecht zur Vorschubrichtung des Läufers 3.

Durch Beaufschlagung der jeweils zugeordneten, piezoelektrischen Aktuatoren 213, 214, 223, 224 mit Steuerspannungen können die Antriebsabschnitte 21, 22 unabhängig voneinander ausgelenkt bzw. bewegt werden, um die durch sie auf den Läufer 3 ausgeübten Vorspannkräfte zu erhöhen oder zu verringern bzw. ganz aufzuheben, und um Antriebskräfte auf den Läufer 3 zu übertragen, um dessen Vorschub zu bewerkstelligen. Die Antriebsabschnitte 21, 22 jeder Antriebsvorrichtung 2 sind dabei senkrecht zur Vorschubrichtung des Läufers 3 benachbart (in Blickrichtung der Figur 1 hintereinander, d.h. in sich überdeckender Weise) angeordnet.

Durch die spezielle Ausgestaltung des Grundrahmens 4 mit den integral mit diesem ausgeführten Festkörpergelenken bzw. aufgrund der entsprechenden Anordnung der Antriebsvorrichtungen 2 an dem Grundrahmen 4 kann die Vorspannkraft zwischen einem ersten Antriebsabschnitt 21 und dem Läufer 3 über eine Zunahme der Vorspannkraft zwischen einem zweiten Antriebsabschnitt 22 und dem Läufer 3 durch das Aufbringen entsprechender Steuerspannungen verringert oder sogar ganz aufgehoben werden. Durch die Erhöhung der Vorspannkraft, mit welcher der zweite Antriebsabschnitt 22 gegen den Läufer 3 drückt, bewirkt die daraus resultierende Gegenkraft, die über die Antriebsvorrichtung 2 auf den Grundrahmen 4 wirkt, eine Verschiebung des Teils des Grundrahmens 4, an welchem die Antriebsvorrichtung 2 angeordnet ist, gegenüber dem jeweils verbleibenden und feststehenden Teil des Grundrahmens 4. Dadurch erfolgt in analoger Weise eine Verschiebung der Antriebsvorrichtung 2, so dass es zu einem Abheben des ersten Antriebsabschnitts 21 kommen kann, dessen ihm zugeordnete Aktuatoren 213, 214 nicht oder gegebenenfalls phasenversetzt oder gegenphasig angesteuert sind (siehe hierzu Fig. 5c, welche die zuvor geschilderte Wirkweise anhand des Sonderfalls des kompletten Abhebens eines Antriebsabschnitts schematisch zeigt).

Vorzugsweise werden die dem ersten Antriebsabschnitt 21 zugeordneten Aktuatoren 213, 214 gegenphasig zu den dem zweiten Antriebsabschnitt 22 zugeordneten Aktuatoren 223, 224 mit Steuerspannungen beaufschlagt, um den oben beschriebenen Effekt zu verstärken, d.h. die Vorspannkraft, die über den ersten Antriebsabschnitt 21 auf den Läufer 3 wirkt, weiter zu reduzieren bzw. ganz aufzuheben. Es liegt aber im Rahmen der Erfindung, dass der oben beschriebene Effekt bereits eintritt, wenn lediglich die dem zweiten Antriebsabschnitt 22 zugeordneten Aktuatoren 223, 224 mit Steuerspannungen beaufschlagt werden, und die dem ersten Antriebsabschnitt 21 zugeordneten Aktuatoren 213, 214 dagegen nicht.

In dem beschriebenen Fall wird angenommen, dass der Läufer 3 im Wesentlichen starr ist und durch die erhöhte Vorspannkraft des entsprechenden Antriebsabschnitts 21, 22 nicht zurückweicht bzw. nachgibt.

Allerdings ist es auch möglich, dass eine Elastizität auf Seiten des Läufers 3 bewerkstelligt wird, in dem der Läufer 3 bei einer durch Beaufschlagung mit Steuerspannungen bedingten Verlängerung der ersten Aktuatoren 213, 214 und entsprechender Auslenkung des zugeordneten ersten Antriebsabschnitts 21 gegenüber einem unverformten Zustand (d.h. in Abwesenheit von Steuerspannungen) zurückweicht. Dies hat zur Folge, dass der zweite Antriebsabschnitt 22, dessen Position in Abwesenheit der Steuerspannungen an den zweiten Aktuatoren 223, 224 in seiner ursprünglichen Position verbleibt, außer Eingriff mit dem Läufer 3 gelangt. Vorzugsweise werden die dem zweiten Antriebsabschnitt 22 zugeordneten Aktuatoren 223, 224 mit Steuerspannungen beaufschlagt, die gegenphasig zu den Steuerspannungen sind, mit welchen die dem ersten Antriebsabschnitt 21 zugeordneten Aktuatoren 213, 214 beaufschlagt sind, um den oben beschriebenen Effekt zu verstärken, d.h. um die von dem zweiten Antriebsabschnitt 22 auf den Läufer 3 ausgeübte Vorspannkraft weiter zu verringern oder gar vollständig aufzuheben.

Die obigen Ausführungen gelten natürlich entsprechend, wenn anstelle des ersten Antriebsabschnitts 21 der zweite Antriebsabschnitt 22 vom Läufer 3 abgehoben wird.

Figur 2 zeigt eine isolierte Antriebsvorrichtung 2, die bei dem erfindungsgemäßen Schreitantrieb zum Einsatz kommt.

Die Aktuatoren 213, 214, 223, 224 sind in einen formveränderlichen Rahmen 20 derart eingesetzt, dass jeweils die beiden auf einen Antriebsabschnitt 21, 22 wirkenden Aktuatoren 213, 214, 223, 224 mit einem ihrer jeweiligen Enden an dem ihnen gemeinsamen Antriebsabschnitt 21, 22 anliegen und sich mit ihrem anderen Ende an einem Abstützabschnitt 215, 216, 225, 226 des Rahmens 20 abstützen.

Der Rahmen 20 ist näherungsweise in Form eines gleichschenkligen Dreiecks ausgebildet, an dessen Spitze sich die Antriebsabschnitte 21, 22 befinden. Die Aktuatoren 213, 214, 223, 224 liegen mit Blickrichtung auf das Dreieck parallel zueinander versetzt hintereinander und bilden die gleich langen Schenkel des Dreiecks. Die Abstützabschnitte 215, 216, 225, 226 befinden sich an den Ecken des Dreiecks und sind über Festkörpergelenke 212, 222 gelenkig an einer Basis 201 des Rahmens 20, die der Hypotenuse des Dreiecks entspricht, festgelegt. Elastische, Federabschnitte 211, 221 verbinden jeden der Antriebsabschnitte 21, 22 einzeln und einstückig mit der Basis des Dreiecks. Die auf denselben Antriebsabschnitt 21 bzw. 22 wirkenden Aktuatoren 213, 214 bzw. 223, 224 wirken in Arbeitsrichtungen, die in einem Winkel von 90° zueinander stehen, wobei der Scheitel des Winkels im Bereich des jeweiligen Antriebsabschnitts 21, 22 liegt.

Die Federabschnitte 211, 221, welche integral mit dem Rahmen 20 ausgeführt sind, erlauben die zum Antrieb des Läufers 3 notwendige Beweglichkeit der Antriebsabschnitte 21, 22. Gleichzeitig erlauben die Federabschnitte 211, 221 genauso wie die Festkörpergelenke 212, 222 eine Ausrichtung der Anlageflächen der Antriebsabschnitte 21, 22 und der Abstützabschnitte 215, 216, 225, 226 gegenüber den Endflächen der Aktuatoren 213, 214, 223, 224, so dass keine ungewollten Kräfte- insbesondere Scherkräfte oder Zugkräfte - in die Aktuatoren durch deren Einspannung in den Rahmen 20 bzw. durch den Betrieb des Schreitantriebs eingeleitet werden, da die piezokeramischen Materialien der Aktuatoren 213, 214, 223, 224 sehr empfindlich auf solche Kräfte reagieren und zu einer Zerstörung derselben führen können.

Die Federabschnitte 211, 221 wirken insbesondere in einer Z-Ebene federnd, die senkrecht zur Basis 201 durch beide Antriebsabschnitte 21, 22 verläuft, und gestatten eine federnde Auslenkung der jeweiligen Antriebsabschnitte 21, 22 in Vorschubrichtung.

Der Aufbau und die Funktionsweise der Federabschnitte 211, 221 wird nachstehend anhand des dem ersten Antriebsabschnitt 21 zugeordneten, ersten Federabschnitts 211 beschrieben. Da beide Federabschnitte 211, 221 identisch aufgebaut sind, gilt die nachstehende Beschreibung für den zweiten Federabschnitt 221, der dem zweiten Antriebsabschnitt 22 zugeordnet ist, entsprechend.

Der erste Federabschnitt 211 umfasst einen Keilabschnitt 211a an der Spitze des dreiecksförmigen Rahmens 20, dessen Spitze nach unten zur Basis 201 des Rahmens 20 weist. An der flachen Seite des Keilabschnitts 211a ist die Reibnase 210 des Antriebsabschnitts 21 angeordnet. Der Keilabschnitt 211a geht an seiner zur Basis 201 weisenden Seite in einen rippenförmigen Steg 211b über, an den sich auf der entgegengesetzten und zur Basis 201 weisenden Seite ein weiterer Keilabschnitt 211c anschließt. Die jeweiligen Spitzen der beiden Keilabschnitte 211a und 211c weisen zueinander und begrenzen den Steg 211b endseitig. Der Steg 211b ist biegeelastisch verformbar und bildet ein Festkörpergelenk zwischen den beiden Keilabschnitten 211a und 211c. Die flache Seite des Keilabschnitts 211c mündet in ein ringförmiges, erstes Lamellenpaket 211d. Das Lamellenpaket 211d ist in Z-Richtung federelastisch ausgebildet und bildet einen ovalen Ring, dessen Hauptachse sich senkrecht zur Z-Ebene parallel zur Basis 201 erstreckt und dessen Nebenachse in der Z-Ebene senkrecht zur Basis 201 durch die Reibnase 210 des Antriebsabschnitts 21 verläuft. An der zur Basis 201 weisenden Seite des Lamellenpakets 211d ist ein würfel- oder quaderförmiger Spannblock 211e ausgebildet, der in einer entsprechenden Ausnehmung der Basis 201 verschieblich (in Z-Richtung) geführt wird. Der Spannblock 211e verbindet das erste Lamellenpaket 211d und ein zweites Lamellenpaket 211f, und ist über letzteres mit der Basis 201 verbunden. Das zweite Lamellenpaket 211f umfasst zwei stegförmige Lamellen, die im Wesentlichen parallel zur Basis 201 auf unterschiedlichen Seiten von dem Spannblock 211e vorstehen und endseitig an die Basis 201 angeschlossen sind. Wie das erste Lamellenpaket 211d ist auch das zweite Lamellenpaket 211f in Z-Richtung federelastisch ausgebildet. Im Vergleich zu dem ersten Lamellenpaket 211d weisen die Lamellen des zweiten Lamellenpakets 211f geringere Materialquerschnitte bei größerer Länge auf. Im Ergebnis ist eine Federkonstante des zweiten Lamellenpakets 211f in Z-Richtung, d.h. eine erforderliche Kraft zur Auslenkung des zweiten Lamellenpakets 211f in Z-Richtung, kleiner als eine Federkonstante des ersten Lamellenpakets 211d. Der Spannblock 211e ist mit einem Innengewinde versehen und wird durch eine mit einem Außengewinde versehene Stellschraube gegenüber der Basis 201 festgelegt, wobei die Stellschraube vorzugsweise von der von dem Spannblock 211e abgewandten Seite der Basis 201 betätigbar ist, um den Abstand des Spannblocks 211e von der Basis 201 einzustellen. Der Federabschnitt 211 ist einstückig aus dem Material des Rahmens 20 ausgebildet. Das bevorzugte Material des Rahmens ist ein Kunststoff mit elastischen Eigenschaften.

Durch Verringern des Abstands zwischen dem Spannblock 211e und der Basis 201 wird der Antriebsabschnitt 21 in Richtung der Basis 201 gezogen, sodass der Keilabschnitt 211a eine Druckkraft auf beide daran anliegenden Aktuatoren ausübt. Durch ein Vergrößern des Abstands zwischen dem Spannblock 211e und der Basis 201 würden die Aktuatoren ggf. auf Zug beansprucht werden, was aufgrund der Empfindlichkeit des keramischen Materials der Aktuatoren zu verhindern ist.

Ein Verfahren zur Ansteuerung des piezoelektrischen Schreitantriebs 1 nach dem ersten Ausführungsbeispiel wird nachstehend mit Bezug auf Figuren 3 (a) bis (j) beschrieben und umfasst folgende Schritte:
Schritt A: Ausgehend von dem in Ansichten (a) = entlang der Vorschubrichtung und (b) = senkrecht zur Vorschubrichtung dargestellten spannungslosen (Grund-)Zustand bzw. Ruhezustand, in welchem keine Steuerspannungen an den Aktuatoren anliegen und sich die Antriebsabschnitte 21, 22 zweier gegenüberliegend angeordneter Antriebsvorrichtungen 2 unter Ausübung einer Vorspannkraft und Blockierung des Läufers 3 in Kontakt mit selbigem befinden, werden die sog. zweiten Aktuatoren von gegenüberliegend angeordneten zweiten Antriebsabschnitten 22 mit einer Steuerspannung beaufschlagt, so dass eine Zunahme der durch diese auf den Läufer 3 ausgeübten Vorspannkraft resultiert. Vorzugsweise werden die sog. ersten Aktuatoren von gegenüberliegend angeordneten ersten Antriebsabschnitten 21 gleichzeitig mit einer phasenversetzten oder gegenphasigen Steuerspannung beaufschlagt. Die Zunahme der durch die zweiten Antriebsabschnitte 22 auf den Läufer 3 aufgebrachten Vorspannkraft bewirkt aufgrund einer entsprechenden Lagerung der Antriebsvorrichtungen eine Verringerung der durch die Antriebsabschnitte 21 auf den Läufer aufgebrachten Vorspannkraft, wobei gegebenenfalls die zusätzliche gegenphasige Ansteuerung der ersten Aktuatoren zu einer weiteren Verringerung der Vorspannkraft auf den Läufer 3 führt, so dass letztlich ein vollständiges Abheben der Antriebsabschnitte 21 von dem Läufer 3 resultiert (Ansicht (c) = entlang der Vorschubrichtung; Ansicht (d) = senkrecht zur Vorschubrichtung).
Schritt B: Ausgehend von dem in Ansichten (c) und (d) dargestellten Zustand werden die zweiten Aktuatoren mit Steuerspannungen beaufschlagt, dass die zweiten Antriebsabschnitte 22 bei bestehendem Kontakt zum Läufer 3 Antriebskräfte in Vorschubrichtung auf den Läufer 3 übertragen und der Läufer 3 entsprechend einen Vorschub gegenüber den ersten Antriebsabschnitten 21 erfährt (Ansicht (e) = entlang der Vorschubrichtung; Ansicht (f) = senkrecht zur Vorschubrichtung). Durch gleichzeitiges, phasenversetzes oder gegenphasiges Ansteuern der ersten Aktuatoren können die ersten Antriebsabschnitte 21 eine der Vorschubrichtung entgegengesetzte Bewegung ausführen und demnach die Schrittweite erhöhen. Die ersten und zweiten Antriebsabschnitte 21, 22 sind nun entlang der Vorschubrichtung des Läufers 3 (geringfügig) versetzt zueinander angeordnet.
Schritt C: Ausgehend von dem in den Ansichten (e) und (f) dargestellten Zustand werden die an den zweiten Aktuatoren angelegten Steuerspannungen und ggf. die an den ersten Aktuatoren angelegten Steuerspannungen geändert, um den Kontakt zwischen den Antriebsabschnitten 21 und dem Läufer 3 wiederherzustellen, so dass sich die ersten und zweiten Antriebsabschnitte 21, 22 in Vorschubrichtung des Läufers 3 versetzt in Kontakt mit Läufer 3 befinden und Vorspannkräfte auf den Läufer 3 ausüben (Ansicht (g) = entlang der Vorschubrichtung; Ansicht (h) = senkrecht zur Vorschubrichtung).
Schritt D: Ausgehend von dem in Ansichten (g) und (h) dargestellten Zustand werden nun die ersten und gegebenenfalls die zweiten Aktuatoren derart mit Steuerspannungen beaufschlagt, dass der Kontakt zwischen den zweiten Antriebsabschnitten 22 und dem Läufer 3 unter Aufhebung der auf den Läufer 3 ausgeübten Vorspannkräfte gelöst wird, während die ersten Antriebsabschnitte 21 bei bestehendem Kontakt zum Läufer 3 weiterhin Vorspannkräfte auf den Läufer 3 ausüben (Ansicht (i) = entlang der Vorschubrichtung; Ansicht (j) = senkrecht zur Vorschubrichtung).
Schritt E: Ausgehend von dem in Ansichten (i) und (j) dargestellten Zustand werden die ersten Aktuatoren derart mit Steuerspannungen beaufschlagt, so dass die ersten Antriebsabschnitte 21 bei bestehendem Kontakt zum Läufer 3 Antriebskräfte in Vorschubrichtung auf den Läufer 3 übertragen und der Läufer 3 einen Vorschub gegenüber dem zweiten Paar der Antriebsabschnitte 22 erfährt. Vorzugsweise werden gleichzeitig die zweiten Aktuatoren derart mit Steuerspannungen beaufschlagt, dass die zweiten Antriebsabschnitte 22 in einem vom Läufer 3 abgehobenen, d.h. kontaktlosen Zustand eine Bewegung im Wesentlichen entgegengesetzt zur Vorschubrichtung ausführen.
Schritt F: Anschließend erfolgt ein Ändern der an den ersten Aktuatoren angelegten Steuerspannungen und gegebenenfalls ein Ändern der an den zweiten Aktuatoren angelegten Steuerspannungen, um den Kontakt zwischen den zweiten Antriebsabschnitten 22 und dem Läufer 3 wiederherzustellen.

Durch wiederholtes Ausführen der vorangehenden Schreitantriebs-Schritte A bis F kann ein linearer Vorschub des Läufers 3 erzielt werden. An die Schreitantriebs-Schritte kann sich ein sogenannter Analogmodus anschließen, bei welchem die Bewegung des Läufers 3 gleichsinnig mit den parallel angesteuerten und ausgelenkten Antriebsabschnitten 21, 22 erfolgt, so dass hier nur ein sehr kleiner und in erster Linie durch die maximale Ausdehnung der Aktuatoren begrenzter Verfahrweg des Läufers 3 möglich ist, welcher jedoch eine sehr hohe Auflösungsgenauigkeit bietet. Nach Erreichen der Zielposition können die Aktuatoren in einen spannungslosen Zustand gebracht werden und halten diese aufgrund der auf den Läufer 3 wirkenden Vorspannung.

### Zweites Ausführungsbeispiel (Fig. 4 bis 6)

Figur 4 zeigt verschiedene Ansichten (a bis c) einer Anordnung von zwei benachbarten Antriebsvorrichtungen 2 für einen piezoelektrischen Schreitantrieb nach einem zweiten Ausführungsbeispiel der Erfindung, wobei zwei identische Antriebsvorrichtungen 2 parallel versetzt zueinander benachbart und in sich überdeckender Weise angeordnet sind und dafür ausgelegt sind, von derselben Seite eines Läufers 3 auf diesen einzuwirken. Die beiden Antriebsvorrichtungen 2 sind parallel zueinander versetzt an einem integral mit einem näherungsweise quaderförmigen Gehäuse ausgebildeten Grundrahmen 4 angeordnet, wobei der Grundrahmen 4 elastisch verformbare Abschnitte in Form von Festkörpergelenken aufweist, mit deren Hilfe die Antriebsabschnitte der Antriebsvorrichtungen 2 gegen einen hier nicht gezeigten Läufer vorgespannt werden können, und die eine elastische Lagerung der Antriebsvorrichtungen 2 erlauben. Die jeweiligen Antriebsabschnitte ragen durch entsprechende Öffnungen des Gehäuses und liegen damit zur Einwirkung auf einen Läufer frei, wobei sie entlang einer Linie angeordnet sind. Die jeweilige Basis des dreiecksförmigen Rahmens der Antriebsvorrichtungen 2 ist gegenüber dem Gehäuse festgelegt, insbesondere verschraubt. Die offen dargestellten Seiten des Gehäuses können durch entsprechende Verkleidungen abgedeckt werden.

Figur 5 zeigt in Ansicht (a) eine Seitenansicht eines piezoelektrischen Schreitantriebs nach dem zweiten Ausführungsbeispiel der Erfindung, wobei der Läufer 3 rollend gegenüber einem Festlager gelagert ist und die auf einem Grundrahmen 4 montierten Antriebsvorrichtungen 2 von derselben Seite auf den Läufer 3 einwirken. Ansicht (b) ist eine schematische Seitenansicht des Schreitantriebs aus Ansicht (a) in einem spannungslosen Zustand in Abwesenheit von an den Aktuatoren anliegenden Steuerspannungen. Die Antriebsvorrichtung 2 ist auf einem ersten Abschnitt 41 des (ortsfesten) Grundrahmens 4 angeordnet, wobei der erste Abschnitt 41 des Grundrahmens 4 über ein Festkörpergelenk 42 mit einem zweiten Abschnitt 43 des Grundrahmens 4 verbunden ist und federnd gegenüber diesem gelagert ist. Ansicht (c) ist eine schematische Seitenansicht des Schreitantriebs aus Ansicht (b) in einem Zustand, in welchem die den zweiten Antriebsabschnitten 22 zugeordneten Aktuatoren mit Steuerspannungen beaufschlagt sind, sodass sich der zweite Antriebsabschnitt 22 unter Erhöhung der Vorspannkraft zu dem Läufer 3 sowie unter Verformung des Festkörpergelenks 42 an dem Läufer 3 abdrückt und somit der erste Antriebsabschnitt 21 von dem Läufer 3 abhebt.

Figur 6 zeigt Draufsichten unterschiedlicher Anordnungen von Antriebsvorrichtungen 2 für einen piezoelektrischen Schreitantrieb nach dem zweiten Ausführungsbeispiel der Erfindung. Die Kennzeichnung der Antriebsabschnitte mit den Buchstaben A und B in den Ansichten (a) und (b) bezieht sich auf die Phasen der Bewegungen der Antriebsabschnitte 21, 22, wobei Antriebsabschnitte mit gleicher Kennzeichnung gleichartige Bewegungen vollführen bzw. die entsprechend zugeordneten Aktuatoren gleichphasig angesteuert werden. Gemäß Ansicht (a) sind die Aktuatoren der beiden Antriebsvorrichtungen 2 spiegelsymmetrisch zueinander angesteuert (BAAB-Anordnung), während sie gemäß Ansicht (b) parallel versetzt zueinander angesteuert sind (ABAB-Anordnung). Denkbar ist zudem die hier nicht gezeigte Art der Ansteuerung der den Antriebsabschnitten 21, 22 zugeordneten Aktuatoren, wonach jeweils die beiden Antriebsabschnitte 21, 22 einer gemeinsamen Antriebsvorrichtung 2 gleichsinnig bzw. gleichphasig angesteuert werden, wobei sich jedoch die Phase der Ansteuersignale für die Aktuatoren einer Antriebsvorrichtung 2 von derjenigen der Ansteuersignale für die Aktuatoren der anderen Antriebsvorrichtung 2 unterscheidet (AABB-Anordnung). Die Ansteuerung gemäß Ansicht (a) ist hierbei aufgrund der symmetrischen Einbringung von Kräften auf den Läufer am vorteilhaftesten.

### Drittes Ausführungsbeispiel (Fig. 7)

Figur 7 zeigt eine Seitenansicht eines piezoelektrischen Schreitantriebs 1 nach einem dritten Ausführungsbeispiel der Erfindung, wobei die Antriebsvorrichtung 2 und deren Anordnung in einem gleichartig ausgeführten Gehäuse identisch zum zweiten Ausführungsbeispiel ausgebildet ist, der Läufer 3 jedoch als Drehscheibe ausgebildet ist und die Antriebsvorrichtungen 2 von derselben Seite im Wesentlichen radial auf den als Drehscheibe ausgebildeten Läufer 3 einwirken. Vorteilhaft ist hier insbesondere die parallele Anordnung der Antriebsabschnitte der Antriebsvorrichtung, die bei dem als Drehscheibe ausgeführten Läufer 3 einen linienartigen Kontakt erlaubt, wobei die Antriebskraft durch Erhöhung der Anzahl parallel nebeneinander angeordneter Antriebsvorrichtungen und damit einer Erhöhung der sich gleichzeitig in Eingriff mit der Friktionsoberfläche befindlichen Antriebsabschnitte vergrößert werden kann.

### Viertes Ausführungsbeispiel (Fig. 8)

Figur 8 zeigt eine Seitenansicht eines piezoelektrischen Schreitantriebs 1 nach einem vierten Ausführungsbeispiel der Erfindung mit einer Antriebsvorrichtung 2 gemäß Figur 2, wobei der Läufer 3 hierbei elastisch in einem Festkörpergelenke aufweisenden Rahmen gelagert ist.

Der Aufbau und das Funktionsprinzip des piezoelektrischen Schreitantriebs 1 gemäß der Erfindung lassen sich in anderen Worten wie folgt umschreiben:
Die Erfindung stellt einen selbsthemmenden Schreitantrieb 1 mit wenigstens einer Antriebsvorrichtung 2 und einem davon angetriebenen Element (Läufer) 3 bereit, wobei jede Antriebsvorrichtung 2 einen Rahmen 20 mit elastisch verformbaren Abschnitten 212, 222 aufweist, in welchen wenigstens vier elektromechanische Aktuatoren 213, 214, 223, 224 eingesetzt sind, wobei jeweils zwei zugehörige Aktuatoren 213, 214 bzw. 223, 224 mit einem ihrer jeweiligen Ende an einem ihnen gemeinsamen Antriebsabschnitt 21, 22 des Rahmens 20 anliegen und sich mit ihrem anderen Ende an einem Abstützabschnitt 215, 216 bzw. 225, 226 des Rahmens 20 abstützen. Die Antriebsabschnitte 21, 22 sind in einem spannungslosen Zustand der Aktuatoren 213, 214 bzw. 223, 224 gegen das anzutreibende Element (Läufer) 3 gepresst.

Der erfindungsgemäße Schreitantrieb ist selbsthemmend im Ruhezustand und erzeugt keine Wärmeentwicklung, da keinerlei Aufschlag mit Steuerspannungen erforderlich ist. Ihm liegt ein nichtmagnetisches und vakuumkompatibles Funktionsprinzip zu Grunde.

### Fünftes Ausführungsbeispiel (Fig. 9)

Figur 9 zeigt in Ansicht (a) eine Draufsicht und in Ansicht (b) eine Seitenansicht eines piezoelektrischen Schreitantriebs 1 nach einem fünften Ausführungsbeispiel der Erfindung. Die Antriebsvorrichtung 2 ist vorzugsweise identisch zu derjenigen aus einem der vorangehenden Ausführungsbeispiele ausgebildet. Der Läufer 3 umfasst im vorliegenden Ausführungsbeispiel einen vorzugsweise exakt oder im Wesentlichen quaderförmigen Körper 30, dessen flächenmäßig größte Seiten der Antriebsvorrichtung 2 einerseits und einer Führungseinrichtung 5 andererseits zugewandt sind. Die Vorschubrichtung V des Läufers 3 verläuft senkrecht zu den flächenmäßig kleinsten Seiten des Körpers 30 und/oder parallel zu den übrigen Seiten davon. An der der Antriebsvorrichtung 2 zugewandten Vorderseite des Körpers 30 befindet sich die Lauffläche 31 des Läufers 3, welche mit den Antriebsabschnitten der Antriebsvorrichtung 2 zusammenwirkt und von diesen angetrieben wird. Die Lauffläche 31 ist vorzugsweise als Laufrinne ausgebildet und parallel zur Vorschubrichtung V des Läufers 3 ausgerichtet, sodass der durch die Antriebsabschnitte bewirkte Vorschub des Läufers 3 gegenüber der Antriebsvorrichtung 2 in Vorschubrichtung V des Läufers 3 geführt wird.

An der der Führungseinrichtung 5 zugewandten Rückseite des Körpers 30 erstreckt sich z.B. mittig davon ein Steg 32 parallel zur Vorschubrichtung V des Läufers 3. In Ansicht (a) der Figur 9, die senkrecht zur Vorschubrichtung V des Läufers 3 verläuft, weist dieser Steg 32 ein im Wesentlichen dreiecksförmiges Querschnittsprofil mit einer zur Führungseinrichtung 5 weisenden Spitze und/oder mit zwei im spitzen Winkel von beispielsweise 45° zur Rückseite des Körpers 30 ausgerichteten Flanken auf.

Die Führungseinrichtung 5 umfasst einen länglichen, näherungsweise quaderförmigen Körper 50, dessen längste Seitenflächen exakt oder im Wesentlichen parallel zur Vorschubrichtung V des Läufers 3 ausgerichtet sind. Ausgehend von einer quaderförmigen Grundform weist der Körper 50 der Führungseinrichtung 5 zwischen der dem Läufer 3 direkt zugewandten Seite und den daran angrenzenden Seitenflächen Schrägflächen 51 auf, die mit der Rückseite des Läufers 3 einen spitzen Winkel von vorzugsweise exakt oder im Wesentlichen 45° einschließen. An diesen Schrägflächen der Führungseinrichtung 5 sind insgesamt vier Laufrollen 52 montiert. Die Drehachsen der Laufrollen 52 sind jeweils senkrecht zu einer der Schrägflächen der Führungseinrichtung 5 und in einem spitzen Winkel von vorzugsweise exakt oder im Wesentlichen 45° zur Rückseite des Läufers 3 ausgerichtet. Die Drehachsen und Mantelflächen der Laufrollen 52 sind derart auf die Flanken am Steg 52 des Läufers 3 abgestimmt, dass die Laufrollen 52 bei einer Bewegung des Läufers 3 entlang der Vorschubrichtung V an den jeweiligen Flanken des Stegs 32 des Läufers 3 abrollen. Der Läufer 3 und/oder die Führungseinrichtung 5 ist/sind vorzugsweise spiegelsymmetrisch ausgebildet/angeordnet bezüglich der Symmetrieebene, die die Vorschubrichtung des Läufers 3 einschließt und zwischen den Antriebsabschnitten derselben Antriebsvorrichtung 2 verläuft. Die Zusammenwirkung von Läufer 3, Führungseinrichtung 5 und Antriebsvorrichtung 2 ermöglicht eine selbständige Ausrichtung der Antriebsvorrichtung 2 gegenüber dem Läufer 3.

### Bezugszeichenliste

- 1: Piezoelektrischer Schreitantrieb
- 2: Antriebsvorrichtung(en)
- 20: Rahmen (der Antriebsvorrichtung)
- 21: Erster Antriebsabschnitt
- 210: Kontaktabschnitt (Reibnase) (des ersten Antriebsabschnitts)
- 211, 221: Federabschnitt
- 211a: Erster Keilabschnitt
- 211b: Steg
- 211c: Zweiter Keilabschnitt
- 211d: Erstes Lamellenpaket
- 211e: Spannblock
- 211f: Zweites Lamellenpaket
- 212, 222: Festkörpergelenk
- 213, 214: Aktuatoren (des ersten Antriebsabschnitts)
- 215, 216: Abstützabschnitte (des ersten Antriebsabschnitts)
- 22: Zweiter Antriebsabschnitt
- 220: Kontaktabschnitt (Reibnase) (des zweiten Antriebsabschnitts)
- 223, 224: Aktuatoren (des zweiten Antriebsabschnitts)
- 225, 226: Abstützabschnitte (des zweiten Antriebsabschnitts)
- 3: Läufer
- 30: Körper
- 31: Steg
- 32: Lauffläche
- 4: Grundrahmen
- 41: Erster Abschnitt
- 42: Flexibler Abschnitt
- 43: Zweiter Abschnitt
- 5: Führungseinrichtung
- 50: Körper
- 51: Schrägfläche
- 52: Laufrolle
- V: Vorschubrichtung

## Patentansprüche

1. Piezoelektrischer Schreitantrieb (1), umfassend wenigstens eine piezoelektrische Antriebsvorrichtung (2) mit wenigstens zwei unabhängig voneinander antreibbaren und parallel angeordneten An- triebsabschnitten (21, 22), auf die jeweils wenigstens zwei piezoelektrische Aktuatoren (213, 214, 223, 224) wirken, und einen Läufer (3), der bei Beaufschlagung der Aktuatoren (213, 214, 223, 224) mit Steuerspannungen einen Vorschub durch wenigstens einen der Antriebsabschnitte (21, 22) erfährt, wobei die Antriebsvorrichtung (2) näherungsweise in Form eines Dreiecks ausgebildet ist, an dessen Spitze die Antriebsabschnitte (21, 22) angeordnet sind, die Antriebsvorrichtung (2) spiegelsymmetrisch zu einer Symmetrieebene, die die Vorschubrichtung des Läufers (3) einschließt und zwischen den Antriebsabschnitten (21, 22) derselben Antriebsvorrichtung verläuft, aufgebaut ist, und wenigstens einer der Antriebsabschnitte (21, 22) in Abwesenheit von an den Aktuatoren (213, 214, 223, 224) anliegenden Steuerspannungen gegen den Läufer (3) vorgespannt ist, **dadurch gekennzeichnet, dass** der Schreitantrieb derart konfiguriert ist, dass wenigstens einer der Antriebsabschnitte (21, 22) in Abwesenheit von an den Aktuatoren (213, 214, 223, 224) anliegenden Steuerspannungen derart gegen den Läufer (3) vorgespannt ist, dass dieser den Vorschub des Läufers (3) blockiert, wobei jeder der Antriebsabschnitte (21, 22) einzeln federnd mit einer gemeinsamen Basis (201) des Dreiecks verbunden ist.

2. Piezoelektrischer Schreitantrieb (1) nach Anspruch 1, **dadurch gekennzeichnet, dass** die Antriebsvorrichtung (2) einen formveränderlichen Rahmen (20) aufweist, in welchen die Aktuatoren (213, 214, 223, 224) derart eingesetzt sind, dass jeweils die beiden auf einen Antriebsabschnitt (21, 22) wirkenden Aktuatoren (213, 214, 223, 224) mit einem ihrer jeweiligen Enden an dem ihnen gemeinsamen Antriebsabschnitt (21, 22) des Rahmens (20) anliegen und sich mit ihrem anderen Ende an einem Abstützabschnitt (215, 216, 225, 226) des Rahmens (20) abstützen.

3. Piezoelektrischer Schreitantrieb (1) nach Anspruch 2, **dadurch gekennzeichnet, dass** der Rahmen (20) elastisch verformbare Abschnitte (211, 212) aufweist.

4. Piezoelektrischer Schreitantrieb (1) nach einem der Ansprüche 2 oder 3, **dadurch gekennzeichnet, dass** wenigstens einer der elastisch verformbaren Abschnitte (211, 221, 212, 222) als Federabschnitt (211, 221) oder als Festkörpergelenk (212, 222) ausgebildet ist, wobei vorzugsweise wenigstens einer der elastisch verformbaren Abschnitte (211, 221, 212, 222) zwischen wenigstens einem der Abstützabschnitte (215, 216, 225, 226) und der Basis (201) des Rahmens (20) und/oder zwischen wenigstens einem der Antriebsabschnitte (21, 22) und der Basis (201) des Rahmens (20) angeordnet ist.

5. Piezoelektrischer Schreitantrieb (1) nach einem der vorangehenden Ansprüche, **dadurch gekennzeichnet, dass** die Aktuatoren (213, 214, 223, 224) wenigstens abschnittsweise die Schenkel des Dreiecks bilden und gelenkig an der Basis (201) des Dreiecks festgelegt sind.

6. Piezoelektrischer Schreitantrieb (1) nach einem der vorangehenden Ansprüche, **dadurch gekennzeichnet, dass** der Schreitantrieb (1) wenigstens zwei Antriebsvorrichtungen (2) aufweist, die auf derselben Seite oder auf unterschiedlichen Seiten des Läufers (3) angeordnet sind, wobei die Antriebsvorrichtungen (2) vorzugsweise spiegelsymmetrisch angeordnet sind und/oder die Antriebsabschnitte (21, 22) spiegelsymmetrisch auslenkbar sind und/oder die den die Antriebsabschnitten (21, 22) zugeordneten Aktuatoren (213, 214, 223, 224) spiegelsymmetrisch verschaltet sind.

7. Piezoelektrischer Schreitantrieb (1) nach einem der vorhergehenden Ansprüche, **dadurch gekennzeichnet, dass** der Läufer (3) elastisch verformbar ausgebildet und/oder gelagert ist und derart konfiguriert ist, dass er in Abwesenheit der Steuerspannungen an den Aktuatoren (213, 214, 223, 224) durch Rückstellkräfte aufgrund elastischer Verformung gegenüber der Antriebsvorrichtung (2) vorgespannt ist.

8. Piezoelektrischer Schreitantrieb (1) nach einem der vorhergehenden Ansprüche, **dadurch gekennzeichnet, dass** wenigstens eine Antriebsvorrichtung (2) an einem Grundrahmen (4) angeordnet ist, wobei der Grundrahmen (4) elastisch verformbare Abschnitte (42), bevorzugt in Form von Festkörpergelenken, aufweist, so dass die Antriebsvorrichtung (2) an dem Grundrahmen (4) derart elastisch lagerbar ist, dass wenigstens einer ihrer Antriebsabschnitte (21, 22) derart konfiguriert ist, dass er in Abwesenheit der Steuerspannungen an den Aktuatoren (213, 214, 223, 224) durch Rückstellkräfte aufgrund elastischer Verformung gegenüber dem Läufer (3) vorgespannt ist.

9. Piezoelektrischer Schreitantrieb (1) nach Anspruch 7 oder 8, **dadurch gekennzeichnet, dass** der Läufer (3) derart gelagert und/oder ausgebildet ist und/oder die Antriebsvorrichtung (2) derart gelagert ist und/oder der Grundrahmen (4) derart konfiguriert ist, dass eine Zunahme der Vorspannkraft zwischen einem der Antriebsabschnitte (21, 22) der Antriebsvorrichtung (2) und dem Läufer (3) zu einer Abnahme der Vorspannkraft zwischen einem anderen Antriebsabschnitt (22, 21) dieser Antriebsvorrichtung (2) und dem Läufer (3) führt.

10. Piezoelektrischer Schreitantrieb (1) nach einem der vorhergehenden Ansprüche, **dadurch gekennzeichnet, dass** der piezoelektrischer Schreitantrieb (1) eine Führungseinrichtung (5) zur Führung des Läufers (3) in Vorschubrichtung (V) gegenüber der Antriebsvorrichtung (2) aufweist.

11. Verfahren zur Ansteuerung eines piezoelektrischen Schreitantriebs (1) nach einem der vorhergehenden Ansprüche, umfassend die Schritte:
a. Schritt A: Ansteuern der wenigstens einem zweiten Antriebsabschnitt (22) zugeordneten, zweiten Aktuatoren (223, 224) und gegebenenfalls Ansteuern der wenigstens einem ersten Antriebsabschnitt (21) zugeordneten, ersten Aktuatoren (213, 214), so dass die vom dem ersten Antriebsabschnitt (21) auf den Läufer (3) aufgebrachte Vorspannkraft verringert oder aufgehoben wird;
b. Schritt B: Ansteuern der zweiten Aktuatoren (223, 224), so dass der zweite Antriebsabschnitt (22) Antriebskräfte auf den Läufer (3) überträgt und der Läufer (3) einen Vorschub in Antriebsrichtung erfährt;
c. Schritt C: Ändern der an den zweiten Aktuatoren (223, 224) angelegten Steuerspannungen und gegebenenfalls Ändern der an den ersten Aktuatoren (213, 214) angelegten Steuerspannungen, um den Kontakt zwischen dem ersten Antriebsabschnitt (21) und dem Läufer (3) wiederherzustellen, wobei die ersten und zweiten Antriebsabschnitte (21, 22) in Antriebsrichtung des Läufers (3) gegeneinander versetzt sind;
d. Schritt D: Ansteuern der ersten Aktuatoren (213, 214) gegebenenfalls Ansteuern der zweiten Aktuatoren (223, 224), so dass die von dem zweiten Antriebsabschnitt (22) auf den Läufer (3) aufgebrachte Vorspannkraft verringert oder aufgehoben wird;
e. Schritt E: Ansteuern der ersten Aktuatoren (213, 214), so dass der erste Antriebsabschnitt (21) Antriebskräfte auf den Läufer (3) überträgt und der Läufer (3) einen Vorschub in Antriebsrichtung erfährt;
f. Schritt F: Ändern der an den ersten Aktuatoren (213, 214) angelegten Steuerspannungen und gegebenenfalls Ändern der an den zweiten Aktuatoren (223, 224) angelegten Steuerspannungen, um den Kontakt zwischen dem zweiten Antriebsabschnitt (22) und dem Läufer (3) wiederherzustellen; und gegebenenfalls
g. Wiederholen der Schritte A bis F, wobei Schritt B bei jeder Wiederholung derart abgewandelt ist, dass ein Ansteuern der zweiten Aktuatoren (223, 224) und der ersten Aktuatoren (213, 214) erfolgt, so dass der zweite Antriebsabschnitt (22) einen Vorschub des Läufers (3) in Antriebsrichtung bewirkt und der erste Antriebsabschnitt (21) eine Bewegung im Wesentlichen entgegengesetzt zu der Antriebsrichtung ausführt.

12. Verfahren zur Ansteuerung eines piezoelektrischen Schreitantriebs (1) nach Anspruch 11, **dadurch gekennzeichnet, dass** bei Schritt B zusätzlich ein Ansteuern der ersten Aktuatoren (213, 214) erfolgt, so dass der erste Antriebsabschnitt (21) eine Bewegung im Wesentlichen entgegengesetzt zu der Antriebsrichtung ausführt und/oder bei Schritt E zusätzlich ein Ansteuern der zweiten Aktuatoren (223, 224) erfolgt, so dass der zweite Antriebsabschnitt (22) eine Bewegung im Wesentlichen entgegengesetzt zu der Antriebsrichtung ausführt.

## Claims

1. Piezoelectric stepper drive (1), comprising at least one piezoelectric drive apparatus (2) with at least two drive sections (21, 22) which are drivable independently of each other and arranged in parallel and each acted upon by at least two piezoelectric actuators (213, 214, 223, 224), and a driven member (3) which is advanced by at least one of said drive sections (21, 22) when control voltages are applied to said actuators (213, 214, 223, 224), where said drive apparatus (2) is configured approximately in the shape of a triangle, at the tip of which said drive sections (21, 22) are arranged, said drive apparatus (2) is in mirror-image symmetry to a plane of symmetry that includes the advance direction of said driven member (3) and extends between said drive sections (21, 22) of the same drive apparatus, and at least one of said drive sections (21, 22) is biased against said driven member (3) in the absence of control voltages applied to said actuators (213, 214, 223, 224), **characterized in that** the stepper drive is configured such that at least one of said drive sections (21, 22) is biased against said driven member (3) in the absence of control voltages applied to said actuators (213, 214, 223, 224) such that said drive section blocks the advance of said driven member (3), where each of said drive sections (21, 22) is connected individually resilient to a common base (201) of said triangle.

2. Piezoelectric stepper drive (1) according to claim 1, **characterized in that** said drive apparatus (2) comprises a deformable frame (20) into which said actuators (213, 214, 223, 224) are inserted such that said two actuators (213, 214, 223, 224) respectively acting upon a drive section (21, 22) abut with one of their respective ends against said drive section (21, 22) of said frame (20) that is common to them and with their other end are supported against a support section (215, 216, 225, 226) of said frame (20).

3. Piezoelectric stepper drive (1) according to claim 2, **characterized in that** said frame (20) comprises elastically deformable sections (211, 212).

4. Piezoelectric stepper drive (1) according to one of the claims 2 or 3, **characterized in that** at least one of said elastically deformable sections (211, 221, 212, 222) is configured as a spring section (211, 221) or as a flexure hinge (212, 222), where preferably at least one of said elastically deformable sections (211, 221, 212, 222) is arranged between at least one of said support sections (215, 216, 225, 226) and said base (201) of said frame (20) and/or between at least one of said drive sections (21, 22) and said base (201) of said frame (20).

5. Piezoelectric stepper drive (1) according to one of the preceding claims, **characterized in that** said actuators (213, 214, 223, 224) at least in sections form the legs of said triangle and are fixed to said base (201) of said triangle in an articulated manner.

6. Piezoelectric stepper drive (1) according to one of the preceding claims, **characterized in that** said stepper drive (1) comprises at least two drive apparatuses (2) which are arranged on the same side or on different sides of said driven member (3), where said drive apparatuses (2) are preferably arranged in mirror-image symmetry and/or said drive sections (21, 22) are deflectable in mirror-image symmetry and/or said actuators (213, 214, 223, 224) associated with said drive sections (21, 22) are connected in mirror-image symmetry.

7. Piezoelectric stepper drive (1) according to one of the preceding claims, **characterized in that** said driven member (3) is configured and/or mounted in an elastically deformable manner and configured such that, in the absence of said control voltages at said actuators (213, 214, 223, 224), it is biased by restoring forces against said drive apparatus (2) due to elastic deformation.

8. Piezoelectric stepper drive (1) according to one of the preceding claims, **characterized in that** at least one drive apparatus (2) is arranged on a base frame (4), where said base frame (4) comprises elastically deformable sections (42), preferably in the form of flexure hinges, so that said drive apparatus (2) is mountable on said base frame (4) in such an elastic manner that at least one of its drive sections (21, 22) is configured such that, in the absence of the control voltages at said actuators (213, 214, 223, 224), it is biased by restoring forces against said driven member (3) due to elastic deformation.

9. Piezoelectric stepper drive (1) according to claim 7 or 8, **characterized in that** said driven member (3) is mounted and/or configured and/or said drive apparatus (2) is mounted and/or said base frame (4) is configured such that an increase in the biasing force between one of said drive sections (21, 22) of said drive apparatus (2) and said driven member (3) leads to a decrease in the biasing force between another drive section (22, 21) of said drive apparatus (2) and said driven member (3).

10. Piezoelectric stepper drive (1) according to one of the preceding claims, **characterized in that** said piezoelectric stepper drive (1) comprises a guide device (5) for guiding said driven member (3) in the advance direction (V) relative to said drive apparatus (2).

11. Method for actuating a piezoelectric stepper drive (1) according to one of the preceding claims, comprising the steps of:
a. step A: actuating said second actuators (223, 224) associated with said at least one second drive section (22) and optionally actuating said first actuators (213, 214) associated with said at least one first drive section (21), so that the biasing force applied to said driven member (3) by said first drive section (21) is reduced or cancelled;
b. step B: actuating said second actuators (223, 224) so that said second drive section (22) transmits drive forces onto said driven member (3) and said driven member (3) is advanced in the drive direction;
c. step C: changing said control voltages applied to said second actuators (223, 224) and optionally changing said control voltages applied to said first actuators (213, 214) to restore the contact between said first drive section (21) and said driven member (3), where said first and said second drive sections (21, 22) are offset from each other in the drive direction of said driven member (3);
d. step D: actuating said first actuators (213, 214) and optionally actuating said second actuators (223, 224) so that the biasing force applied to said driven member (3) by said second drive section (22) is reduced or canceled;
e. step E: actuating said first actuators (213, 214) so that said first drive section (21) transmits drive forces onto said driven member (3) and said driven member (3) is advanced in the drive direction;
f. step F: changing said control voltages applied to said first actuators (213, 214) and optionally changing said control voltages applied to said second actuators (223, 224) to restore the contact between said second drive section (22) and said driven member (3); and optionally
g. repeating steps A to F, where step B is modified for each repetition such that said second actuators (223, 224) and said first actuators (213, 214) are actuated so that said second drive section (22) causes an advance of said driven member (3) in the drive direction and said first drive section (21) performs a motion in a direction substantially opposite to the drive direction.

12. Method for actuating a piezoelectric stepper drive (1) according to claim 11, **characterized in that** step B additionally includes an actuation of said first actuators (213, 214) so that said first drive section (21) performs a motion in the direction substantially opposite to the drive direction and/or in step E said second actuators (223, 224) are additionally actuated so that said second drive section (22) performs a motion in a direction substantially opposite to the drive direction.

## Revendications

1. Entraînement piézoélectrique pas à pas (1), comprenant au moins un dispositif d'entraînement piézoélectrique (2) avec au moins deux sections d'entraînement (21, 22) pouvant être entraînées indépendamment l'une de l'autre et disposées parallèlement, sur lesquelles agissent respectivement au moins deux actionneurs piézoélectriques (213, 214, 223, 224), et un rotor (3) qui, lorsqu'il est sollicité, agit sur les actionneurs (213, 214, 223, 224), 214, 223, 224) avec des tensions de commande, le dispositif d'entraînement (2) subit une avance à travers au moins une des sections d'entraînement (21, 22), dans lequel le dispositif d'entraînement (2) a approximativement la forme d'un triangle, au sommet duquel les sections d'entraînement (21, 22) sont disposées, le dispositif d'entraînement (2) est symétrique par rapport à un plan de symétrie, qui comprend la direction d'avance du rotor (3) et s'étend entre les sections d'entraînement (21, 22) du même dispositif d'entraînement, et au moins une des sections d'entraînement (21, 22) est précontrainte contre le rotor (3) en l'absence de tensions de commande appliquées aux actionneurs (213, 214, 223, 224), **caractérisé en ce que** l'entraînement pas à pas est configuré de telle sorte que **en ce qu'**au moins une des sections d'entraînement (21, 22) est précontrainte contre le rotor (3) en l'absence de tensions de commande appliquées aux actionneurs (213, 214, 223, 224) de telle sorte que le rotor (3) bloque l'avance du rotor (3), chacune des sections d'entraînement (21, 22) étant individuellement reliée de manière élastique à une base commune (201) du triangle.

2. Entraînement piézoélectrique pas à pas (1) selon la revendication 1, **caractérisé en ce que** le dispositif d'entraînement (2) présente un cadre (20) de forme variable dans lequel les actionneurs (213, 214, 223, 224) sont insérés de telle manière que les deux sont reliés chacun à une section d'entraînement (21), 22), reposent avec une de leurs extrémités respectives sur la section d'entraînement (21, 22) du cadre (20) qui leur est commune et sont appuyés avec leur autre extrémité sur une section de support (215, 216, 225, 226) du cadre (20).

3. Entraînement piézoélectrique à pied (1) selon la revendication 2, **caractérisé en ce que** le cadre (20) présente des sections élastiquement déformables (211, 212).

4. Entraînement piézoélectrique de marche (1) selon l'une des revendications 2 ou 3, **caractérisé en ce qu'au** moins l'une des sections élastiquement déformables (211, 221, 212, 222) est conçue comme une section à ressort (211, 221) ou comme une articulation à semi-conducteurs (212, 222), dans lequel de préférence au moins une des sections élastiquement déformables (211, 221, 212, 222) est disposée entre au moins une des sections de support (215, 216, 225, 226) et la base (201) du cadre (20) et/ou entre au moins une des sections d'entraînement (21, 22) et la base (201) du cadre (20).

5. Entraînement piézoélectrique pas à pas (1) selon l'une des revendications précédentes, **caractérisé en ce que** les actionneurs (213, 214, 223, 224) forment au moins en partie les branches du triangle et sont articulés à la base (201) du triangle.

6. Entraînement pas à pas piézoélectrique (1) selon l'une des revendications précédentes, **caractérisé en ce que** l'entraînement pas à pas (1) comprend au moins deux dispositifs d'entraînement (2) disposés sur le même côté ou sur des côtés différents du rotor (3), dans lequel les dispositifs d'entraînement (2) sont de préférence disposés de manière symétrique et/ou les sections d'entraînement (21, 22) peuvent être déviées de manière symétrique et/ou les actionneurs (213, 214, 223, 224) associés aux sections d'entraînement (21, 22) sont reliés de manière symétrique.

7. Entraînement piézoélectrique pas à pas (1) selon l'une des revendications précédentes, **caractérisé en ce que** le rotor (3) est élastiquement déformable et/ou supporté et est configuré de telle sorte qu'en l'absence de tensions de commande au niveau des actionneurs (213, 214, 223, 224), il est précontraint par rapport au dispositif d'entraînement (2) par des forces de rappel dues à la déformation élastique.

8. Entraînement piézoélectrique de marche (1) selon l'une des revendications précédentes, **caractérisé en ce qu'**au moins un dispositif d'entraînement (2) est disposé sur un cadre de base (4), le cadre de base (4) présentant des sections élastiquement déformables (42), de préférence sous la forme de joints à l'état solide, de sorte que le dispositif d'entraînement (2) puisse être monté élastiquement sur le cadre de base (4) de telle sorte qu'au moins une de ses sections d'entraînement (21, 22) soit configurée de telle sorte qu'en l'absence des tensions de commande au niveau des actionneurs (213, 214, 223, 224), elle soit sollicitée vers le rotor (3) par des forces de rappel dues à la déformation élastique.

9. Entraînement piézoélectrique pas à pas (1) selon la revendication 7 ou 8, **caractérisé en ce que** le rotor (3) est monté et/ou conçu et/ou le dispositif d'entraînement (2) est monté et/ou le cadre de base (4) est configuré de telle manière qu'une augmentation de la force de précontrainte entre l'une des sections d'entraînement (21, 22) du dispositif d'entraînement (2) et le rotor (3) entra ne une diminution de la force de précontrainte entre une autre section d'entraînement (22, 21) de ce dispositif d'entraînement (2) et le rotor (3).

10. Entraînement piézoélectrique pas à pas (1) selon l'une des revendications précédentes, **caractérisé en ce que** l'entraînement piézoélectrique pas à pas (1) présente un dispositif de guidage (5) pour guider le rotor (3) dans le sens de l'avance (V) par rapport au dispositif d'entraînement (2).

11. Procédé de commande d'un entraînement piézoélectrique pas à pas (1) selon l'une des revendications précédentes, comprenant les étapes suivantes
a. Etape A : commande des seconds actionneurs (223, 224) affectés à au moins une seconde section d'entraînement (22) et, si nécessaire, commande des premiers actionneurs (213, 214) affectés à au moins une première section d'entraînement (21) de manière à réduire ou à annuler la force de précontrainte appliquée au rotor (3) par la première section d'entraînement (21) ;
b. Etape B : Commande des deuxièmes actionneurs (223, 224) de sorte que la deuxième section d'entraînement (22) transmette les forces d'entraînement au curseur (3) et que le curseur (3) subisse une avance dans le sens de l'entraînement ;
c. Etape C : modification des tensions de commande appliquées aux seconds actionneurs (223, 224) et, si nécessaire, modification des tensions de commande appliquées aux premiers actionneurs (213, 214) afin de rétablir le contact entre la première section d'entraînement (21) et le rotor (3), les première et seconde sections d'entraînement (21, 22) étant décalées l'une par rapport à l'autre dans le sens de l'entraînement du rotor (3) ;
d. Etape D : l'entraînement des premiers actionneurs (213, 214), le cas échéant l'entraînement des seconds actionneurs (223, 224) de sorte que la force de précontrainte appliquée au rotor (3) par la seconde section d'entraînement (22) soit réduite ou annulée ;
e. Etape E : Commande des premiers actionneurs (213, 214) de sorte que la première section d'entraînement (21) transmette les forces d'entraînement au curseur (3) et que le curseur (3) subisse une avance dans le sens de l'entraînement ;
f. Etape F : modification des tensions de commande appliquées aux premiers actionneurs (213, 214) et, si nécessaire, modification des tensions de commande appliquées aux seconds actionneurs (223, 224) pour rétablir le contact entre la seconde section d'entraînement (22) et le rotor (3) ; et, si nécessaire
g. Répétition des étapes A à F, dans laquelle l'étape B est modifiée à chaque répétition de telle sorte que les seconds actionneurs (223, 224) et les premiers actionneurs (213, 214) sont entraînés de telle sorte que la seconde section d'entraînement (22) fait avancer le rotor (3) dans le sens de l'entraînement et que la première section d'entraînement (21) effectue un mouvement sensiblement opposé au sens de l'entraînement.

12. Procédé d'entraînement d'un entraînement piézoélectrique pas à pas (1) selon la revendication 11, **caractérisé en ce que** dans l'étape B, les premiers actionneurs (213, 214) sont en outre entraînés de telle sorte que la première section d'entraînement (21) exécute un mouvement sensiblement opposé à la direction d'entraînement et/ou dans l'étape E, les deuxièmes actionneurs (223, 224) sont en outre entraînés de telle sorte que la deuxième section d'entraînement (22) exécute un mouvement sensiblement opposé à la direction d'entraînement.
